# EUROPÄISCHE PATENTSCHRIFT

(11) **EP 0 454 962 B1**
(45) Veröffentlichungstag und Bekanntmachung des Hinweises auf die Patenterteilung: **24.05.1995**
(21) Anmeldenummer: 91102873.6
(22) Anmeldetag: 27.02.1991
(51) Int. Cl.: G01R 31/308

(54) **Verfahren und Vorrichtung zum Prüfen von Leiterplatten**
Method and device for testing printed circuit cards
Procédé et dispositif pour tester des cartes imprimées

(30) Priorität: 02.05.1990 DE 4014149
(43) Veröffentlichungstag der Anmeldung: 06.11.1991
(73) Patentinhaber: Grundig E.M.V. Elektro-Mechanische Versuchsanstalt Max Grundig GmbH & Co. KG, 90762 Fürth (DE)
(72) Erfinder: Wagner, Hans, Grundig E.M.V., Max Grundig, W-8510 Fürth (DE)

(56) Entgegenhaltungen:
- DE-A- 2 937 929
- US-A- 4 869 206

## Beschreibung

Die Erfindung betrifft ein Verfahren und eine Vorrichtung zur optischen Kontrolle von konventionell bestückten, mischbestückten und mit nur oberflächenmontierbaren Bauteilen bestückten Leiterplatten, entsprechend dem jeweiligen Oberbegriff der Ansprüche 1 und 3.

Bei automatischen Bestückungsvorrichtungen bildet die Prüfung auf fehlerfreie Bestückung von Leiterplatten in Bezug auf Vorhandensein und Plazierung der eingesetzten Bauteile einen wichtigen Faktor im Produktionsprozess. In diesem Zusammenhang bietet die optische Kontrolle mit Videokameras und Bildanalyseeinheiten vorteilhafte Lösungsmöglichkeiten.

Eine häufig angewendete Methode zur optischen Prüfung mit Videokameras ist das Differenzbildverfahren, das in der Zeitschrift "PKI - Technische Mitteilungen", 1988, Heft 1, Seiten 101 und 102, beschrieben wird. Dort wird mit einer Videokamera eine korrekt bestückte Leiterplatte aufgenommen. Ausgehend von dieser Aufnahme wird jeweils das Videosignal der Aufnahme der zu testenden Leiterplatte subtrahiert. Auf diese Weise entsteht ein Differenzbild, auf dem nur die Unterschiede der beiden Bilder zu sehen sind. Bei diesem Verfahren werden zwar fehlerhaft bestückte Leiterplatten erkannt, aber auch Unterschiede, beispielsweise durch gleiche Bauteile, die lediglich verschiedene Farben haben, führen zur Fehleranzeige.

Eine weitere Möglichkeit, die auf Seite 102 der oben genannten Zeitschrift beschrieben wird, ist die Kantendetektion. Bei diesem Verfahren werden die Bauteilkanten, d.h. Hell-/Dunkel- oder Dunkel-/Hellübergänge, auf Vorhandensein und richtige Lage überprüft. Diese Art der Leiterplattenkontrolle greift jedoch nur dann, wenn sich die Bauteilkante gegen die Umgebung abhebt.

Bessere Ergebnisse werden mit einem Verfahren erhalten, das den Schattenwurf von Bauteilen auswertet. Im einfachsten Fall beleuchtet man die Prüffläche von schräg oben mit einer Lichtquelle und nimmt ein Bild auf, das in einer Bildverarbeitungseinheit ausgewertet wird. Aus den Schattenflächen, die mit einer Referenz verglichen werden, kann man auf die Lage der Bauelemente schließen. Bei aufeinanderfolgender Beleuchtung aus mehreren, vorzugsweise aus vier Richtungen, wobei bei jeder Beleuchtungsrichtung ein Bild mit der Videokamera aufgenommen wird, kann die Lage und Größe der auf der Leiterplatte vorhandenen Bauteile bestimmt werden. Auch hier führt der Vergleich mit Referenzwerten zu einer Aussage über richtige bzw. fehlerhafte Bestückung. Bei zunehmender Miniaturisierung der Bauteile wird die Leiterplattenkontrolle mit diesem Verfahren immer ungenauer. Vor allem in Nachbarschaft größerer Bauteile können die kleineren leicht verdeckt werden.

Bei allen bekannten Verfahren wird außerdem die Auswertung deshalb sehr schwierig, weil jeweils die Lage der Bauteile bezogen auf die Prüfeinrichtung gemessen wird und somit bei einem leichten Versatz der zu untersuchenden Leiterplatte Fehler in der Auswertung auftreten können.

Es ist deshalb Aufgabe der Erfindung, ein Verfahren anzugeben, mit dem die Auswertung bei der optisch-elektrischen Leiterplattenkontrolle mit mehr Sicherheit bei einfacherer Auswertung erfolgt.

Diese Aufgabe wird durch ein Verfahren nach Anspruch 1 gelöst.
Gemäß der Erfindung wird zur Prüfung auf fehlerfreie Bestückung einer Leiterplatte die Größe der hell reflektierenden Anschlußflächen, die zur Verbindung mit dem Bauelement dienen und die nicht vom Bauteil verdeckt werden, ausgewertet. Es wird also nicht die Absolutlage der Baueile auf der Leiterplatte, sondern die relative Lage der Bauteile zu ihren Anschlußflächen ausgewertet.

Aus der DE-A-29 37 929 ist ein Verfahren und eine Vorrichtung zur optischen Prüfung von Leiterplatten bekannt, bei dem die zu prüfenden Leiterplatten beleuchtet werden und das von der Platte reflektierte Licht über eine Linse auf eine Fotodiodenanordnung fällt, mit der ein Abbild der reflektierenden Teile der Platte gebildet wird. Auf die gleiche Weise wird das Abbild einer Referenzleiterplatte gebildet. In einer Vergleichsschaltung werden die Abbilder verglichen und bei einer Abweichung der Abbilder um einen vorgebbaren Grenzwert wird ein Fehlersignal ausgegeben.

Bei der Bestückung mit SMDs (Surface Mounted Devices) werden zunächst die Bauteile auf die Anschlußflächen aufgeklebt. Bei diesem Vorgang bleibt ein Teil der Anschlußflächen frei, während ein anderer Teil bedeckt wird. Bei richtiger Positionierung der Bauteile wird jeweils ein bestimmter Teil der Anschlußfläche verdeckt. Der Anteil der verdeckten bzw. der freibleibenden Anschlußfläche liegt als Referenzwert vor. Dieser Referenzwert kann aus der Aufnahme einer fehlerfrei bestückten Leiterplatte gewonnen werden oder er kann theoretisch aus den Entwurfsdaten für die Leiterplatte errechnet werden.

Für eine fehlerfreie Auswertung ist eine schattenfreie Beleuchtung notwendig, damit die freibleibenden Anschlußflächen, die wegen ihrer silbrigen, glatten Oberfläche stark reflektieren, nicht durch Schattenbildung verdeckt werden. Die Beleuchtung muß deshalb flächenhaft und diffus sein. Die Kamera wird über der Leiterplatte angeordnet, so daß das direkt reflektierte Licht der silbrigen Anschlußflächen aufgenommen werden kann. Das zum aufgenommenen Bild gehörende Videosignal wird dann einer Bildverarbeitungseinheit zur Auswertung zugeführt. Die Auswertung erfolgt durch Auszählung der hellen Bildpunkte, d.h. Bildpunkten, die einen bestimmten Helligkeitsgrenzwert überschreiten, woraus auf die Größe der Anschlußfläche geschlossen wird. Für jede zu einem Bauteil gehörenden Anschlußfläche ist ein Referenzwert vorhanden, mit dem der Wert der freibleibenden Anschlußfläche eines Bauteils verglichen wird. Um den Referenzwert sind kleinere Abweichungen von wenigen Prozent zugelassen, wobei die Größe der zulässigen Abweichung von der geforderten Bestückungsgenauigkeit abhängt. Es wird somit ein Grenzbereich bzw. Toleranzbereich gebildet, der als Referenz dient. Wird festgestellt, daß der nicht verdeckte Teil einer Anschlußfläche kleiner oder größer als zugelassen ist, wird ein Bestückungsfehler erkannt.

In einer vorteilhaften Ausgestaltung der Erfindung wird auch die Gestalt der nicht bedeckten Anschlußfläche als Auswertungskriterium hinzugezogen, so daß auch die Art der Fehlpositionierung festgestellt werden kann. So ergibt sich bei Verschiebung eines SMD in Diagonalrichtung eine "L"-Form der unbedeckten Anschlußfläche, während eine Drehung des Bauteils eine "V"-Form ergibt.

Bei Bestückung mit konventionellen Bauteilen ergibt sich beispielsweise für ein unbestücktes Lötauge eine Kreisform, für ein bestücktes Lötauge ergibt sich eine "C"-Form, da das Bauteil einen Teil des Lötauges überdeckt und durch die diffuse Reflexion bei der Bildaufnahme dunkel erscheint.

Zur Überprüfung von verlöteten SMDs werden in den Hauptreflexionsrichtungen der Lötstellen zusätzliche Videokameras mit an diese Relflexionsrichtungen angepaßte optische Achsen zur Bildaufnahme angebracht. Auf den Bildern, die diese Kameras erzeugen, erscheinen die ungelöteten Anschlußflächen dunkel, wenn die Reflexionsrichtung der Leiterplatte nicht mit den optischen Achsen der Videokameras übereinstimmen. Die schiefen Flächen der Lötstellen reflektieren dagegen unter einem Winkel zur Leiterplatte, der mit den Achsrichtungen der Kameras zusammenfällt. Mit den in diesen Reflexionsrichtungen angebrachten Kameras wird die Lötfläche hell aufgenommen. Da die Bauteile meist senkrecht oder waagrecht angeordnet sind und auf zwei Seiten Lötflächen haben, müssen für diesen Test vorzugsweise vier Videokameras angebracht werden.

Eine Vorrichtung zur Durchführung des Verfahrens nach Anspruch 1 wird durch die Merkmale nach Anspruch 3 beschrieben. Die Ansprüche 4 bis 7 beschreiben bevorzugte Ausführungsformen.

Im folgenden wird die Erfindung an Hand der Figuren 1 bis 4 erläutert. Es zeigen:
- Fig. 1: schematische Anordnung zur Durchführung des Verfahrens
- Fig. 2: Positionen von SMDs (Surface Mounted Devices)
- Fig. 3: Lötaugen bestückt und unbestückt
- Fig. 4: Anordnung zur Prüfung verlöteter SMDs

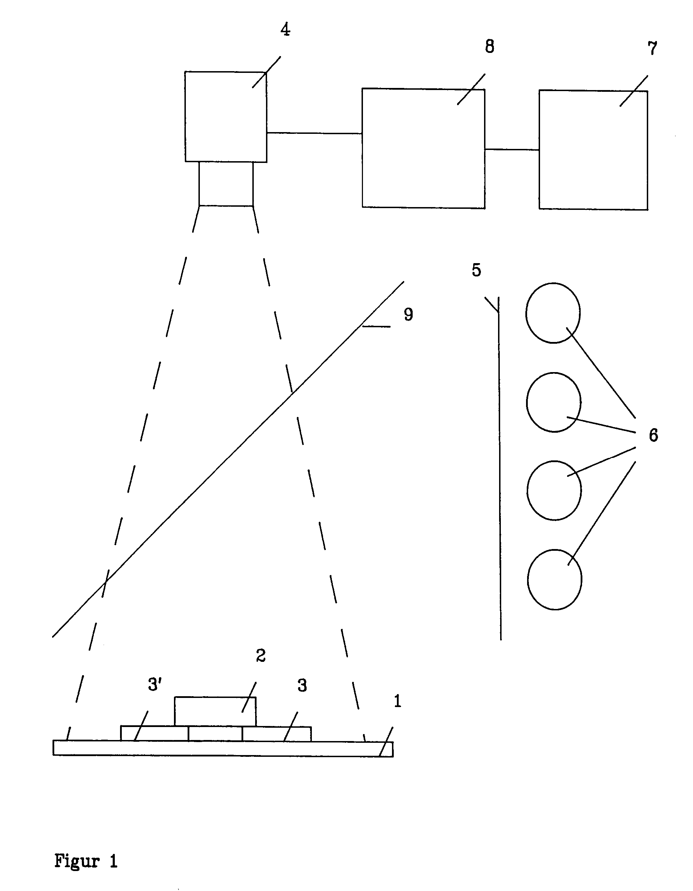

In Figur 1 befindet sich auf der Leiterplatte 1 beispielhaft ein oberflächenmontierbares Bauteil 2, das auf den Anschlußflächen 3 und 3 sitzt. Über der Leiterplatte ist eine Kamera 4 angebracht, die mit einer Bildverarbeitungseinheit 8 entsprechend Fig. 1 verbunden ist, an die ein Monitor angeschlossen sein kann. Die flächenhafte Lichtquelle 6 ist hinter einer Mattscheibe 5 angebracht und sendet sein Licht durch diese Mattscheibe 5 auf einen halbdurchlässigen Spiegel 9, der das flächenhafte und diffuse Licht auf die Leiterplatte 1 umlenkt. Auf diese Weise wird die notwendige schattenfreie Beleuchtung erzeugt, wobei hier auch ein Ringlicht, das um das Kameraobjektiv angebracht ist, verwendbar ist.

Von den silbrigen Anschlußflächen 3 und 3′ wird ein Teil durch das SMD 2 verdeckt, der andere, sichtbare Teil reflektiert das Licht der Beleuchtung vorwiegend in Richtung Kamera und wird somit von der Videokamera als helle Fläche aufgenommen und gegebenenfalls auf dem Montor 7 zur Sichtprüfung angezeigt. Außerdem wird das von der Videokamera aufgenommene Bild an eine Bildsignalverarbeitungseinheit gegeben, in der die Größe und Form der sichtbaren Anschlußflächen (in der Figur ohne Schraffur dargestellt) an Hand von Referenzwerten ausgewertet wird.

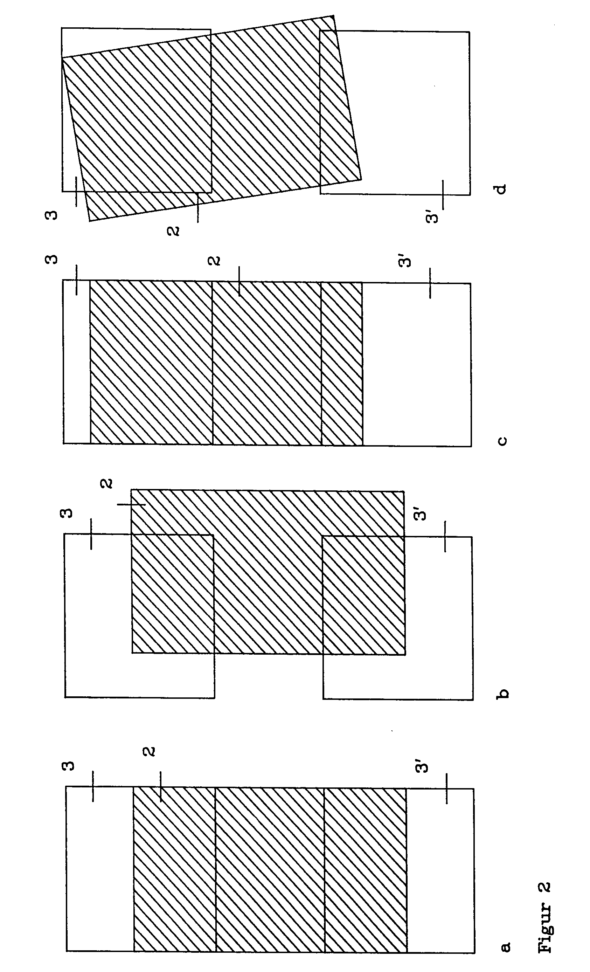

In den Figuren 2a bis 2d werden mögliche Positionen von SMDs in Bezug auf die Anschlußflächen dargestellt.

Figur 2a zeigt ein Bauteil 2 in Sollposition. Die vom Bauteil nicht verdeckten Teile der Anschlußflächen 3 und 3 haben rechteckige Form und sind gleich groß. In Figur 2b ist das Bauteil 2 nach rechts verschoben, die Fläche der nicht verdeckten Anschlußflächen, von der Kamera als helle Fläche aufgenommen, vergrößert sich. Auch bei den Verschiebungen in den Figuren 2c und 2d, in denen das Bauteil 2 nach oben verschoben ist bzw. verdreht aufgesetzt ist, vergrößert oder verkleinert sich zumindest bei einer Anschlußfläche 3 oder 3′ der sichtbare Teil, d.h. eine Fehlpositionierung wird dann erkannt, wenn sich zumindest bei einer der beiden Anschlußflächen eines SMDs der sichtbare Teil vergrößert oder verkleinert. Nach dem gleichen Prinzip kann bereits bei der unbestückten Leiterplatte erkannt werden, ob Teile der Anschlußflächen von einem Fremdkörper bedeckt sind. Die Auswertung erfolgt durch Zählen der hellen Bildpunkte im Bereich des Bauteils, wobei Referenzwerte in Bezug auf Position und Größe der hellen Bildteile durch Auswerten einer fehlerfrei bestückten oder unbestückten Leiterplatte gewonnen oder aus den Entwurfdaten für die Leiterplatte errechnet werden. Bei aufwendigerer Bildverarbeitung kann durch zusätzliches Auswerten der Form der unbedeckten Anschlußflächen die Art der Fehlpositionierung festgestellt werden. So ergeben nach rechts bzw. links verschobene Bauteile, dargestellt in Figur 2b, eine "L"-Form der unbedeckten Anschlußflächen. Verdrehte Bauteile, dargestellt in Figur 2d, ergeben eine "V"-Form. Bei nach oben bzw. nach unten veschobenen Bauteilen, dargestellt in Figur 2c, verändern sich die Seitenverhältnisse der sichtbaren Rechtecke der Anschlußflächen.

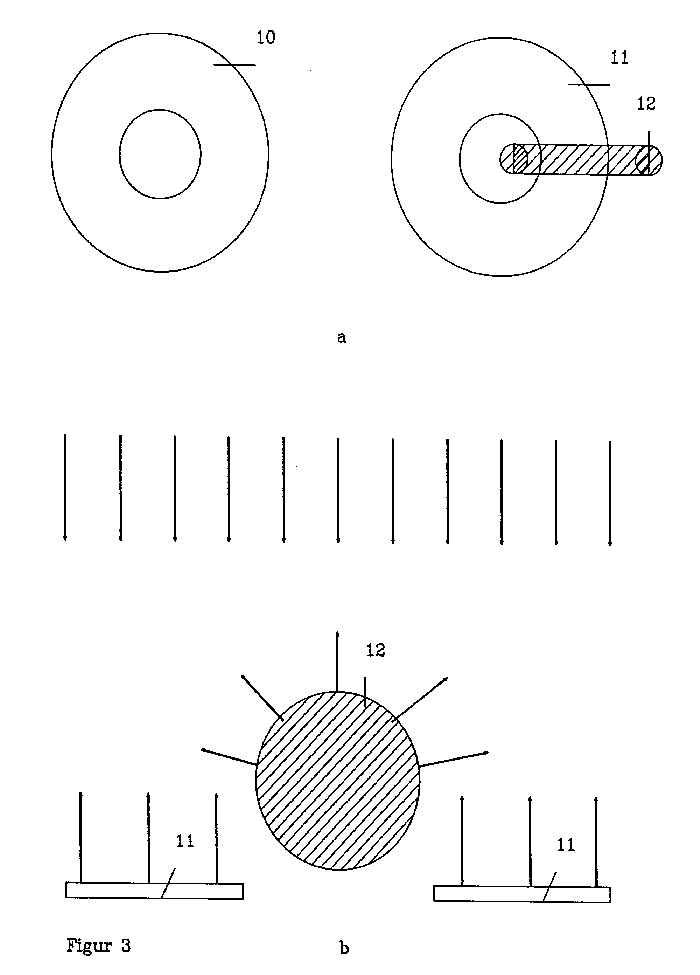

Figur 3a zeigt ein bestücktes und ein unbestücktes Lötauge. Bei der Bildaufnahme ergibt sich für das unbestückte Lötauge 10 ein heller Kreis, der beim bestückten Lötauge 11 durch das Anschlußstück 12 eines Bauteils unterbrochen ist. Das Anschlußstück 12 erscheint gemäß Figur 3b dunkel bei der Bildaufnahme, da das Licht beim Auftreffen auf das Anschlußstück nach allen Seiten und nur ein kleiner Teil in Richtung der Kamera reflektiert wird.

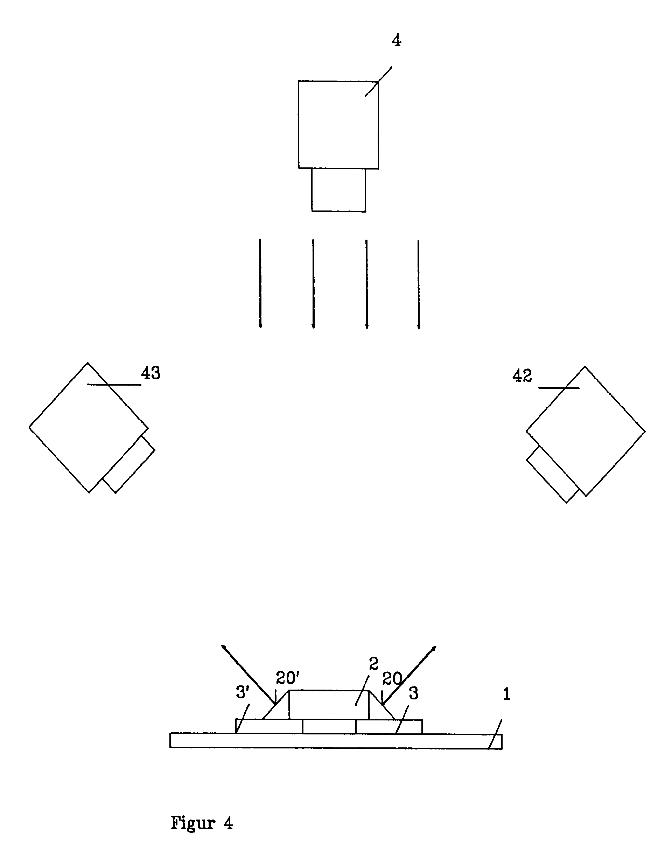

In Figur 4 ist eine Anordnung dargestellt, mit der die Lötflächen von auf den Anschlußflächen aufgelöteten SMDs überprüft werden können. Das Licht fällt im wesentlichen senkrecht auf die Leiterplatte 1 aus Richtung der Kamera 4 ein und wird von den verlöteten Flächen 20 und 20′ in Richtung der Kameras 42 bzw. 43 reflektiert. Bei den Bildern, die mit der Kamera 42 bzw. 43 aufgenommen werden, bilden die Lötflächen 20 bis 20′ helle Streifen, während sie bei Aufnahme mit Kamera 4 dunkel erscheinen. Dagegen erscheinen Flächen, die nicht von geneigten Lötflächen bedeckt sind bei Bildern der Kamera 4 hell und bei den Kameras 42 und 43 dunkel. Auch hier erfolgt die Auswertung mit Hilfe der Bildverarbeitungseinheit durch Vergleich mit einer Referenz oder durch Sichtprüfung auf dem Monitor oder mehreren Monitoren.

Da Bauteile auch gegenüber dem in Figur 4 dargestellten Bauteil 2 um 90° um die Achse Kamera-Bauteil gedreht sein könnnen, müssen auch in diesen zusätzlichen Reflexionsrichtungen zwei weitere Kameras angebracht sein, um eine vollständige Prüfung der Lötflächen zu gewährleisten.

Anstelle der vier zusätzlichen Kameras d.h. der Kameras 42, 43 und der in den zusätzlichen Reflexionsrichtungen angebrachten zwei weiteren Kameras, können zusätzlich vier flächenhafte, gerichtet strahlende Lichtquellen seitlich angebracht sein, so daß die Bildaufnahme mit nur einer Kamera erfolgt, wobei ein Bild mit Normalbeleuchtung von oben aufgenommen wird und ein zweites bei Beleuchtung mit den zusätzlichen Lichtquellen. Mit dem erfindungsgemäßen Verfahren bzw. mit der erfindungsgemäßen Vorrichtung kann sowohl eine Bestückungskontrolle als auch eine Lötstellenkontrolle durchgeführt werden. Bei fortschreitender Miniaturisierung der Bauteile muß nicht das Verfahren, sondern nur die Auflösung geändert werden.

## Patentansprüche

1. Verfahren zur optischen Prüfung von Leiterplatten (1), wobei die zu prüfenden Leiterplatten (1) schattenfrei beleuchtet werden, mit einer Videokamera (4) oder mehreren Videokameras (4,42,43) Bilder dieser Leiterplatten (1) aufgenommen werden, wobei die Videosignale zur Auswertung an eine Bildverarbeitungseinheit (8) und gegebenenfalls an einen Monitor (7) weitergeleitet werden, und wobei zur Prüfung auf Vorhandensein und der Plazierung der Bauelemente (2) oder deren Verlötung oder auf Fremdkörper die Größen derjenigen stark reflektierenden, nicht durch die Bauelemente (2) oder Fremdkörper verdeckten Anschlußflächen (3, 3′) der Leiterplatte (1), die zur Verbindung mit den Bauelementen (2) dienen, dadurch bestimmt werden, daß für jede dieser Anschlußflächen (3, 3′) eines zu erwartenden Bauelementes (2) die Zahl der diesen Anschlußflächen (3,3′) entsprechenden Bildpunkte, deren Helligkeit einen vorgegebenen Helligkeitsgrenzwert überschreiten, ermittelt wird,
**dadurch gekennzeichnet**, daß das Nichtvorhandensein und die falsche Position eines Bauelements (2) oder seine fehlerhafte Verlötung oder das Vorhandensein eines Fremdkörpers erkannt wird, wenn die Größen der Anschlußflächen (3, 3′) bzw. die entsprechenden Zahlen der Bildpunkte nicht zwischen einem oberen und einem unteren Grenzwert liegen.

2. Verfahren nach Anspruch 1,
**dadurch gekennzeichnet**, daß
ein fehlerhafter Versatz eines Bauelements (2) bezogen auf die Anschlußflächen (3, 3′) zusätzlich durch Auswertung der Gestalt der unbedeckten Anschlußflächen (3, 3′) erkannt wird.

3. Vorrichtung zur Durchführung des Verfahrens nach Anspruch 1 oder 2, mit
einer flächenhaften, diffus strahlenden Lichtquelle (5, 6), mit der die zu prüfende Leiterplatte (1) schattenfrei beleuchtet wird, einer Videokamera (4), die über der Leiterplatte (1) angeordnet ist, und einer Bildverarbeitungseinheit (8) zur Messung der Größe stark reflektierender Anschlußflächen (3, 3′),
**dadurch gekennzeichnet**, daß diese Bildverarbeitungseinheit (8) Zähl- und Vergleichselemente beinhaltet, mit denen die Meßwerte bestimmt werden bzw. das Nichtvorhandensein und die fehlerhafte Plazierung eines Bauelementes (2) erkannt werden, wenn die Meßwerte nicht zwischen einem oberen und einem unteren Grenzwert liegen.

4. Vorrichtung nach Anspruch 3,
**dadurch gekennzeichnet,** daß
ein oder mehrere Monitore (7) zur Bildkontrolle angeschlossen sind.

5. Vorrichtung nach Anspruch 3,
**dadurch gekennzeichnet**, daß
das Licht der Lichtquelle (5, 6) über einen halbdurchlässigen Umlenkspiegel (9) in den Strahlengang der Kamera (4) eingeführt wird.

6. Vorrichtung nach Anspruch 3,
**dadurch gekennzeichnet,** daß
sie zur Prüfung der Lötstellen an den Bauelementen (2) zusätzlich weitere Kameras (42, 43) mit unterschiedlich ausgerichteten optischen Achsen enthält, die die geneigten oder gewölbten Lötflächen (20, 20′) erfassen.

7. Vorrichtung nach Anspruch 3,
**dadurch gekennzeichnet**, daß
zur Prüfung der Lötstellen an den Bauelementen (2) zusätzlich mehrere flächenhafte, gerichtet strahlende Lichtquellen mit unterschiedlicher Strahlungsrichtung über den Lötstellen bzw. Leiterplatten (1) angeordnet sind, wobei die unterschiedlichen Strahlungsrichtungen so ausgelegt sind, daß das Licht der Lichtquellen von den Lötflächen (20, 20′) in Richtung der Kamera (4) reflektiert wird.

## Claims

1. Process for the optical examination of printed circuit . boards (1), whereby the printed circuit boards (1) to be examined are illuminated in shadow-free manner, images of said printed circuit boards (1) are recorded by means of a video camera (4) or several video cameras (4, 42, 43), the video signals being passed for evaluation to an image-processing unit (8) and, where appropriate, to a monitor (7), and whereby for the purpose of checking for the presence and the positioning of the components (2) or the soldering thereof or for extraneous bodies the magnitudes of the strongly reflecting connecting faces (3, 3′) of the printed circuit board (1) that are not covered by the components (2) or by extraneous bodies and that serve to make the connection to the components (2) are determined by the number of the image points that correspond to said connecting faces (3, 3′) and that have a brightness exceeding a predetermined brightness limit being ascertained for each of said connecting faces (3, 3′) of a component (2) to be expected,
characterised in that the absence of and the incorrect position of a component (2) or its incorrect soldering or the presence of an extraneous body is detected when the magnitudes of the connecting faces (3, 3′) or the corresponding numbers of image points do not lie between an upper and a lower limit.

2. Process according to Claim 1,
characterised in that an incorrect offset of a component (2) in relation to the connecting faces (3, 3′) is detected in addition by evaluation of the shape of the uncovered connecting faces (3, 3′).

3. Device for implementing the process according to Claim 1 or 2, with a planar light source (5, 6) radiating diffusely, with which the printed circuit board (1) to be examined is illuminated in shadow-free manner, a video camera (4) arranged above the printed circuit board (1) and an image-processing unit (8) for measuring the magnitude of strongly reflecting connecting faces (3, 3′),
characterised in that said image-processing unit (8) includes counting and comparing elements with which the measured values are determined and, where appropriate, the absence and the incorrect positioning of a component (2) are detected when the measured values do not lie between an upper and a lower limit.

4. Device according to Claim 3,
characterised in that one or several monitors (7) are connected for the purpose of image-monitoring.

5. Device according to Claim 3,
characterised in that the light from the light source (5, 6) is introduced into the light path of the camera (4) via a semi-transparent deflecting mirror (9).

6. Device according to Claim 3,
characterised in that with a view to examining the soldered joints on the components (2) it additionally includes further cameras (42, 43) with differently oriented optical axes, which register the inclined or convex soldering faces (20, 20′).

7. Device according to Claim 3,
characterised in that with a view to examining the soldered joints on the components (2) in addition several planar light sources radiating directionally and having different directions of radiation are arranged above the soldered joints or the printed circuit boards (1), whereby the different directions of radiation are designed in such a way that the light from the light sources is reflected from the soldering faces (20, 20′) in the direction of the camera (4).

## Revendications

1. Procédé pour le contrôle optique de plaquettes à circuits imprimés (1), selon lequel on éclaire, sans ombres, les plaquettes à circuits imprimés (1) à contrôler, on enregistre les images de ces plaquettes à circuits imprimés (1) à l'aide d'une caméra vidéo (4) ou de plusieurs caméras vidéo (4,42,43), on retransmet les signaux vidéo en vue de leur évaluation à une unité de traitement d'images (8) et éventuellement à un moniteur (7) et selon lequel pour contrôler la présence et le positionnement des composants (2) ou leur brasage ou pour contrôler la présence de corps étrangers, on détermine les valeurs des surfaces de raccordement (3,3′) de la plaquette à circuits imprimés (1), qui réalisent une forte réflexion, ne sont pas masquées par les composants (2) ou par des corps étrangers et sont utilisées pour la liaison avec les composants (2), par le fait que pour chacune de ces surfaces de raccordement (3,3′) d'un composant (2), auquel on peut s'attendre, on détermine le nombre des points d'image, qui correspondent à ces surfaces de raccordement (3,3′) et dont la luminosité dépasse une valeur limite prédéterminée, caractérisé en ce que l'absence et la position erronée d'un composant (2) ou son brasage défectueux ou la présence d'un corps étranger est identifiée lorsque les valeurs des surfaces de raccordement (3,3′) ou les nombres correspondants des points d'image ne sont pas situés entre une valeur limite supérieure et une valeur limite inférieure.

2. Procédé suivant la revendication 1, caractérisé par le fait qu'un décalage erroné d'un composant (2) par rapport aux surfaces de raccordement (3,3′) est identifié en outre par évaluation de la configuration de la surface de raccordement non recouverte (3,3′).

3. Dispositif pour la mise en oeuvre du Procédé suivant la revendication 1 ou 2, comportant une source de lumière (5,6) d'une certaine étendue en surface, qui émet d'une manière diffuse et au moyen de laquelle la plaquette à circuits imprimés (1) à contrôler est éclairée sans ombres, une caméra vidéo (4), qui est disposée au-dessus de la plaquette à circuits imprimés (1), et une unité de traitement d'images (8) servant à mesurer la valeur de surfaces de raccordement (3,3′) réalisant une réflexion intense, caractérisé par le fait que cette unité de traitement d'images (8) contient des éléments de comptage et de comparaison, au moyen desquels les valeurs de mesure sont déterminées ou bien l'absence et le positionnement erroné d'un composant (2) sont identifiés, lorsque les valeurs de mesure ne sont pas situées entre une valeur limite supérieure et une valeur limite inférieure.

4. Dispositif suivant la revendication 3, caractérisé par le fait qu'un ou plusieurs moniteurs (7) sont raccordés pour le contrôle d'images.

5. Dispositif suivant la revendication 3, caractérisé en ce que la lumière de la source de lumière (5,6) est introduite, par l'intermédiaire d'un miroir de renvoi semi-transparent (9), dans le trajet du rayonnement de la caméra (4).

6. Dispositif suivant la revendication 3, caractérisé en ce que pour le contrôle des points de brasage sur les composants (2), il comporte en outre d'autres caméras (42,43) ayant des axes optiques orientés différemment et qui détectent les surfaces de brasage inclinées ou cintrées (20,20′).

7. Dispositif suivant la revendication 3, caractérisé en ce qu'en outre plusieurs sources lumineuses possédant une certaine étendue en surface et émettant un rayonnement dirigé et comportant des directions de rayonnement différentes sont disposées au-dessus des points de brasage ou des plaquettes à circuits imprimés (1) pour le contrôle des points de brasage sur les composants (2), des directions différentes de rayonnement étant choisies de telle sorte que la lumière des sources de lumière est réfléchie par les surfaces de brasage (20,20′) en direction de la caméra (4).
